# EUROPEAN PATENT APPLICATION

(11) **EP 3 196 993 A1**
(43) Date of publication of application: **26.07.2017**
(21) Application number: 15861032.9
(22) Date of filing: 04.11.2015
(51) Int. Cl.: H01S 5/022

(54) **SEMICONDUCTOR LASER DEVICE AND METHOD FOR MANUFACTURING SAME**

(30) Priority: 17.11.2014 JP 2014232637
(71) Applicant: Fujikura Ltd., Tokyo 135-8512 (JP)
(72) Inventor: KATAGIRI Ken, Sakura-shi Chiba 285-8550 (JP); TOYOHARA Nozomu, Sakura-shi Chiba 285-8550 (JP)
(74) Representative: Cabinet Plasseraud
(86) International application number: PCT/JP2015/081023
(87) International publication number: WO 2016/080188

(57) **Abstract**

A semiconductor laser apparatus includes: a semiconductor laser device that emits laser beam in a first direction; a collimator lens that collimates a component in a second direction perpendicular to the first direction among components of laser beam emitted from the semiconductor laser device; and a lens fixing block having a lens mounting surface perpendicular to a third direction perpendicular to the first and second directions. A first end portion of the collimator lens in the third direction is fixed to the lens mounting surface of the lens fixing block by a fixing resin, and a fillet is formed on each of two crossing surfaces in the first end portion fixed by the fixing resin.

## Description

### TECHNICAL FIELD

The present invention relates to a semiconductor laser apparatus and a method of manufacturing the same.

Priority is claimed on Japanese Patent Application No. 2014-232637, filed on November 17, 2014, the content of which is incorporated herein by reference.

### BACKGROUND ART

A semiconductor laser apparatus has features, such as a small size and low power consumption (high energy conversion efficiency) compared with a gas laser or a solid laser. For this reason, semiconductor laser apparatuses are widely used in consumer applications (for example, light sources of optical pickups) and industrial applications (for example, excitation light sources of fiber lasers). Such a semiconductor laser apparatus includes a semiconductor laser device for emitting laser beam and a collimator lens for collimating the laser beam emitted from the semiconductor laser device.

Here, the laser beam emitted from the semiconductor laser device spreads more widely in a direction (fast axis) perpendicular to the pn junction surface of the semiconductor laser device than in a direction (slow axis) parallel to the pn junction surface of the semiconductor laser device. Therefore, as the collimator lens described above, a collimator lens (fast axis collimator lens: FAC lens) for collimating the fast axis component of the laser beam emitted from the semiconductor laser device is used.

The following Patent Document 1 discloses a semiconductor laser apparatus. In the semiconductor laser apparatus, a lens fixing base is provided on a base on which a semiconductor laser device is mounted, and a collimator lens is resin-fixed on the lens fixing base. The collimator lens is disposed so as to face a laser beam emitting portion of the semiconductor laser device. In addition, the following Patent Document 1 discloses another semiconductor laser apparatus. In the semiconductor device, a lens fixing base whose upper portion is recessed is provided on a base, and a part of the collimator lens is resin-fixed within the recessed portion of the lens fixing base in a non-contact state. Accordingly, positional deviation of the collimator lens due to contraction (for example, curing contraction) or expansion (for example, hygroscopic expansion) of resin can be reduced.

The following Patent Document 2 discloses a semiconductor laser apparatus. In the semiconductor laser apparatus, a lens fixing base is provided on a base on which a semiconductor laser device is mounted, and both ends of the collimator lens are resin-fixed so that the collimator lens is interposed in the axial direction by the lens fixing base. In the semiconductor laser apparatus, the positional deviation of the collimator lens due to contraction or expansion of the resin can be limited to the length direction (direction along the slow axis) of the collimator lens. Accordingly, it is possible to reduce the positional deviation of the collimator lens in a direction along the fast axis and a direction along the emission direction of the laser beam.

### PRIOR ART DOCUMENTS

### PATENT DOCUMENTS

[Patent Document 1] Japanese Unexamined Patent Application, First Publication No. 2011-187525
[Patent Document 2] Japanese Unexamined Patent Application, First Publication No. 2004-273545

### DISCLOSURE OF INVENTION

### PROBLEMS TO BE SOLVED BY THE INVENTION

Incidentally, the first semiconductor laser apparatus disclosed in Patent Document 1 described above has a structure in which the collimator lens is resin-fixed on the lens fixing base. For this reason, if contraction or expansion of the resin occurs, the position of the collimator lens may deviate in a direction along the fast axis and the performance may be degraded. In contrast, the second semiconductor laser apparatus disclosed in Patent Document 1 described above has a structure of being resin-fixed to the lens fixing base whose upper portion is recessed. Therefore, although the positional deviation of the collimator lens can be reduced, there is a possibility that the cost will increase because it is necessary to use the lens fixing base having a recessed upper portion.

The semiconductor laser apparatus disclosed in Patent Document 2 described above has a structure in which both ends of the collimator lens are resin-fixed to the lens fixing base. In such a structure, in order to increase the fixing strength, resin fixing may be performed so that a fillet is formed at both ends of the collimator lens. The fillet refers to a resin that protrudes from between surfaces to be fixed. Here, the fillet refers to a resin that protrudes from between the end surface of the collimator lens and the lens fixing base and spreads to the side surface of the collimator lens.

When the fillet is formed on the side surface of the collimator lens, a distance between the center of gravity of the resin and the center of gravity of the lens in the direction along the fast axis and the direction along the emission direction of laser beam increases. Contraction or expansion of the resin is performed with the center of gravity of the resin as a reference. That is, the resin contracts toward the center of gravity of the resin, and expands with the center of gravity of the resin as the center. For this reason, there is a problem that positional deviation of the collimator lens in the direction along the fast axis and the direction along the emission direction of laser beam occurs if the distance between the centers of gravity increases as described above.

In the semiconductor laser apparatuses disclosed in Patent Documents 1 and 2 described above, it is thought that miniaturization and cost reduction can be achieved by using a short collimator lens. In the case of using such a short collimator lens, it is necessary to dispose the lens fixing base and the collimator lens close to the laser beam emitting portion of the semiconductor laser device.

In the second semiconductor laser apparatus disclosed in Patent Document 1 described above, a part of the collimator lens is disposed within the recessed portion of the lens fixing base. For this reason, the thickness of the side wall of the recessed portion may be reduced in order to dispose the collimator lens close to the laser beam emitting portion of the semiconductor laser device. This may significantly increase the cost. In the semiconductor laser apparatus disclosed in Patent Document 2 described above, the resin (resin for fixing the collimator lens) applied to the lens fixing base adheres to the laser beam emitting portion of the semiconductor laser device. As a result, the yield may become worse.

The present invention has been made in view of the above situation, and it is an object of the present invention to provide a semiconductor laser apparatus, which can effectively reduce the positional deviation of a collimator lens due to contraction or expansion of a resin and which can be manufactured with a high yield without a significant increase in cost, and a method of manufacturing the same.

### MEANS FOR SOLVING THE PROBLEMS

In order to solve the problem described above, a semiconductor laser apparatus according to a first aspect of the present invention includes: a semiconductor laser device that emits laser beam in a first direction; a collimator lens that collimates a component in the second direction perpendicular to a first direction among components of laser beam emitted from the semiconductor laser device; and a lens fixing block having a lens mounting surface perpendicular to a third direction perpendicular to the first and second directions. A first end portion of the collimator lens in the third direction is fixed to the lens mounting surface of the lens fixing block by a fixing resin. A fillet is formed on each of two crossing surfaces in the first end portion fixed by the fixing resin.

The collimator lens may be fixed to the lens mounting surface in a state in which the collimator lens protrudes from the lens fixing block toward the semiconductor laser device. The fillet may be formed on a side surface of the collimator lens, which is a side surface opposite to a side facing the semiconductor laser device, and an end surface of the collimator lens, which is an end surface of a portion protruding from the lens fixing block toward the semiconductor laser device.

The fillet formed on the side surface of the collimator lens may have a shape that rises as a distance from the collimator lens decreases on the lens mounting surface. The fillet formed on the end surface of the collimator lens may have a shape that rises as a distance from the collimator lens decreases on a surface facing the semiconductor laser device of two surfaces crossing the lens mounting surface of the lens fixing block.

The fillet formed on the side surface of the collimator lens and the fillet formed on the end surface of the collimator lens may have approximately the same volume.

The collimator lens may be fixed to the lens mounting surface such that an extension line of a centroidal line of the collimator lens parallel to the third direction crosses the lens mounting surface.

In the lens fixing block, the surface facing the semiconductor laser device of the two surfaces crossing the lens mounting surface may be disposed at a position away from the semiconductor laser device by a distance obtained by adding an amount of protrusion of the collimator lens from the lens fixing block to a working distance of the collimator lens.

The fixing resin may be an ultraviolet curable resin or a thermosetting resin.

The second direction may be a direction along a fast axis of laser beam emitted from the semiconductor laser device.

A method of manufacturing a semiconductor laser apparatus according to a second aspect of the present invention is a method of manufacturing a semiconductor laser apparatus including a semiconductor laser device that emits laser beam in a first direction, a collimator lens that collimates a component in a second direction perpendicular to the first direction among components of laser beam emitted from the semiconductor laser device, and a lens fixing block having a lens mounting surface perpendicular to a third direction perpendicular to the first and second directions. The method includes: rotating a substrate, on which the semiconductor laser device and the lens fixing block are mounted, such that the lens mounting surface faces vertically upward; applying a fixing resin onto the lens mounting surface of the lens fixing block; arranging the collimator lens, which is disposed along a vertical direction, at a position where the fixing resin is applied from above the lens mounting surface; adjusting a relative position between the collimator lens and the semiconductor laser device by horizontally moving one of the collimator lens and the substrate; and curing the fixing resin.

The step of applying the fixing resin may include applying the fixing resin at a position, which is more distant than a working distance of the collimator lens, on the lens mounting surface.

The step of adjusting the relative position between the collimator lens and the semiconductor laser device may include adjusting the relative position between the collimator lens and the semiconductor laser device such that the collimator lens protrudes from the lens fixing block toward the semiconductor laser device.

The step of adjusting the relative position between the collimator lens and the semiconductor laser device may include adjusting the relative position between the collimator lens and the semiconductor laser device such that the collimator lens protrudes from the lens fixing block toward the semiconductor laser device and a centroidal line of the collimator lens crosses the lens mounting surface.

### EFFECTS OF THE INVENTION

According to the above aspects of the present invention, since a fillet is formed on each of the two crossing surfaces in the end portion of the collimator lens fixed by the fixing resin, it is possible to reduce the distance between the centroidal line of the collimator lens and the centroidal line of the fixing resin. Therefore, it is possible to effectively reduce the positional deviation of the collimator lens due to contraction or expansion of the fixing resin.

In addition, according to the above aspect of the present invention, the substrate is rotated such that the lens mounting surface of the lens fixing block faces vertically upward, the fixing resin is applied onto the lens mounting surface, the collimator lens disposed along the vertical direction is disposed at a position where the fixing resin is applied, the relative position between the collimator lens and the semiconductor laser device is adjusted by horizontally moving the collimator lens, and then the fixing resin is cured. Therefore, it is possible to manufacture a semiconductor laser apparatus, which can effectively reduce the positional deviation of the collimator lens due to contraction or expansion of the fixing resin, with a high yield without a significant increase in cost.

### BRIEF DESCRIPTION OF DRAWINGS

FIG. 1 is a plan view of a semiconductor laser apparatus according to an embodiment of the present invention.
FIG. 2 is a front view of the semiconductor laser apparatus according to the embodiment of the present invention.
FIG. 3 is a right side view of the semiconductor laser apparatus according to the embodiment of the present invention.
FIG. 4 is a perspective view showing a collimator lens provided in the semiconductor laser apparatus according to the embodiment of the present invention.
FIG. 5A is a diagram for explaining the amount of protrusion of the collimator lens in the embodiment of the present invention.
FIG. 5B is a diagram for explaining the amount of protrusion of the collimator lens in the embodiment of the present invention.
FIG. 6A is a diagram for explaining the fixing strength of the collimator lens.
FIG. 6B is a diagram for explaining the fixing strength of the collimator lens.
FIG. 6C is a diagram for explaining the fixing strength of the collimator lens.
FIG. 7 is a perspective view for explaining a method of manufacturing a semiconductor laser apparatus according to an embodiment of the present invention.
FIG. 8A is a process diagram showing the method of manufacturing a semiconductor laser apparatus according to the embodiment of the present invention.
FIG. 8B is a process diagram showing the method of manufacturing a semiconductor laser apparatus according to the embodiment of the present invention.
FIG. 8C is a process diagram showing the method of manufacturing a semiconductor laser apparatus according to the embodiment of the present invention.
FIG. 8D is a process diagram showing the method of manufacturing a semiconductor laser apparatus according to the embodiment of the present invention.
FIG. 9 is a diagram schematically showing a fixing resin applied to a lens fixing block in the embodiment of the present invention.
FIG. 10 is a perspective view showing a first modification example of the lens fixing block in the embodiment of the present invention.
FIG. 11A is a perspective view showing a second modification example of the lens fixing block in the embodiment of the present invention.
FIG. 11B is a perspective view showing the second modification example of the lens fixing block in the embodiment of the present invention.
FIG. 12 is a plan view showing a third modification example of the lens fixing block in the embodiment of the present invention.
FIG. 13 is a plan view showing a modification example of the collimator lens in the embodiment of the present invention.

### EMBODIMENTS FOR CARRYING OUT THE INVENTION

Hereinafter, a semiconductor laser apparatus and a method of manufacturing the same according to an embodiment of the present invention will be described in detail with reference to the diagrams. In the following explanation, in order to facilitate understanding, the positional relationship among respective members will be described while referring to the XYZ orthogonal coordinate system (the position of the origin is appropriately changed) set in the diagrams as necessary. In the diagrams referred to below, in order to facilitate understanding, the dimension of each member is appropriately changed for illustration as necessary.

### [Semiconductor laser apparatus]

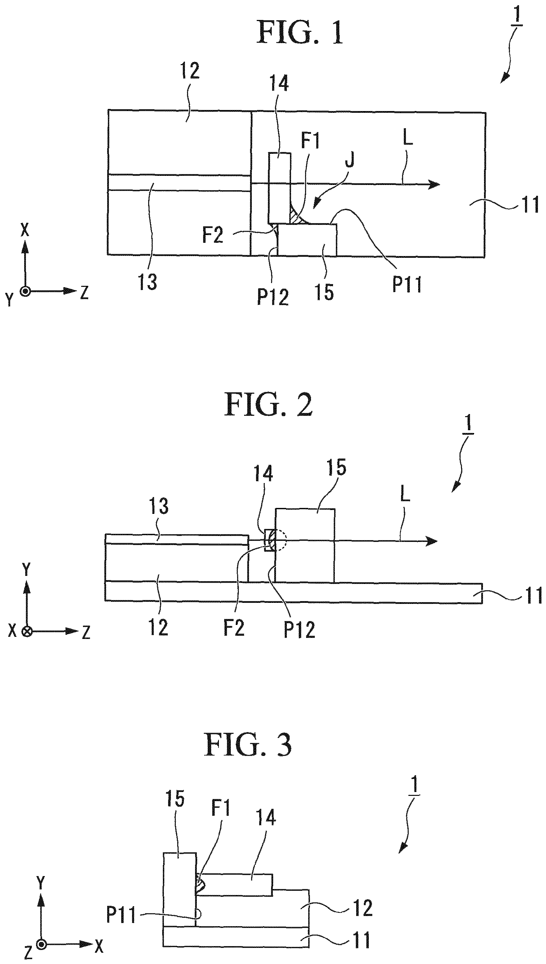

FIG. 1 is a plan view of a semiconductor laser apparatus according to an embodiment of the present invention. FIG. 2 is a front view of the semiconductor laser apparatus. FIG. 3 is a right side view of the semiconductor laser apparatus. As shown in FIGS. 1 to 3, a semiconductor laser apparatus 1 of the present embodiment includes a substrate 11, a submount 12, a semiconductor laser device 13, a collimator lens 14, and a lens fixing block 15. Laser beam L emitted from the semiconductor laser device 13 is collimated (converted into parallel light) to be emitted to the outside.

The XYZ orthogonal coordinate system shown in FIGS. 1 to 3, the +Z direction (first direction) of the Z axis is set to the emission direction of laser beam L. The X axis (third direction) of the XYZ orthogonal coordinate system is set to be parallel to a direction (slow axis) parallel to the pn junction surface of the semiconductor laser device 13. The Y axis (second direction) is set to be parallel to a direction (fast axis) perpendicular to the pn junction surface of the semiconductor laser device 13.

The substrate 11 is a plate-shaped member having a rectangular shape in plan view on which the submount 12, the semiconductor laser device 13, the collimator lens 14, and the lens fixing block 15 described above are mounted.

The submount 12 is a member on which the semiconductor laser device 13 is mounted, and is a rectangular plate-shaped member whose length in the Z direction in plan view is shorter than the substrate 11. The substrate 11 and the submount 12 are formed of a material having a high thermal conductivity in order to enhance the heat dissipation efficiency of the semiconductor laser device 13 and having a small coefficient of thermal expansion in order to minimize stress caused by a temperature change. For example, ceramics, such as aluminum nitride (AlN), or metal, such as molybdenum (Mo), are suitable. As shown in FIGS. 1 to 3, the submount 12 is attached to one end portion (end portion in the -Z direction) of the substrate 11.

The semiconductor laser device 13 is attached to a central portion (central portion in the X direction) on the submount 12 with the laser beam emitting portion facing the +Z side, and emits the laser beam L in the +Z direction in a case where a driving current is supplied from a drive circuit (not shown). The wavelength of the laser beam L emitted from the semiconductor laser device 13 is, for example, approximately 0.9 µm. The semiconductor laser device 13 is mounted on the submount 12 so that the pn junction surface is parallel to the ZX plane.

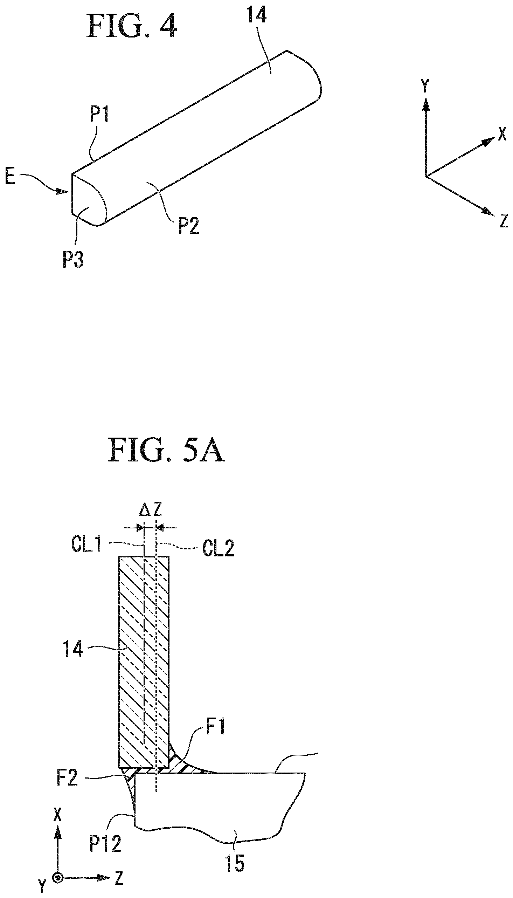

The collimator lens 14 is a fast axis collimator lens (FAC lens) that is disposed on the +Z side of the semiconductor laser device 13 to collimate the fast axis component of the laser beam L emitted from the semiconductor laser device 13. The collimator lens 14 does not collimate the slow axis component of the laser beam L emitted from the semiconductor laser device 13. FIG. 4 is a perspective view showing the collimator lens included in the semiconductor laser apparatus according to the embodiment of the present invention.

As shown in FIG. 4, the collimator lens 14 is a rod-shaped member whose side surfaces are a plurality of flat surfaces and cylindrical surfaces. Specifically, the collimator lens 14 is a transparent rod-shaped member in which an incidence surface P1, which is a flat surface on which the laser beam L from the semiconductor laser device 13 is incident, and an emission surface P2, which is a cylindrical surface from which the laser beam L is emitted, are formed on the side surface and which extends in the X direction. A portion other than the incidence surface P1 and the emission surface P2 on the side surface of the collimator lens 14 is a flat surface forming an angle of 90° with respect to the incidence surface P1. The length of the collimator lens 14 in the X direction is approximately 2 mm.

The lens fixing block 15 is a substantially rectangular parallelepiped member formed of, for example, glass, and has a lens mounting surface P11 parallel to the YZ plane. As shown in FIGS. 1 to 3, the lens fixing block 15 is on the +Z side of the submount 12, and is attached to an end portion shifted in the -X direction from the central portion of the substrate 11. The lens fixing block 15 is fixed to the upper surface of the substrate 11 using an ultraviolet curable resin or a thermosetting resin.

An end portion E (refer to FIG. 4) of the collimator lens 14 is fixed to a lens mounting surface P11 of the lens fixing block 15 using a fixing resin J. As shown in FIGS. 1 to 3, the collimator lens 14 is disposed on the +Z side of the semiconductor laser device 13 so that the longitudinal direction of the collimator lens 14 becomes the X direction. As the fixing resin J, for example, an ultraviolet curable resin or a thermosetting resin can be used.

Specifically, the collimator lens 14 is fixed to the lens mounting surface P11 in a cantilevered manner in a state in which the collimator lens 14 protrudes from the lens fixing block 15 to the semiconductor laser device 13 side (-Z side). Fillets F1 and F2 are formed on two crossing surfaces (the emission surface P2 and an end surface P3) in the end portion E of the collimator lens 14. The fillets F1 and F2 are the fixing resin J protruding from between two surfaces to be fixed, that is, between the end surface P3 of the collimator lens 14 and the lens mounting surface P11 of the lens fixing block 15.

The fillet F1 is formed at a corner where the emission surface P2 of the collimator lens 14 and the lens mounting surface P11 of the lens fixing block 15 cross each other, and the fillet F2 is formed at a corner where the end surface P3 of the collimator lens 14 and a side surface P12 (surface crossing the lens mounting surface P11 and facing the semiconductor laser device 13 side) of the lens fixing block 15 cross each other. Specifically, the fillet F1 has a shape that rises as the distance from the collimator lens 14 decreases on the lens mounting surface P11. The fillet F2 has a shape that rises as the distance from the collimator lens 14 decreases on the side surface P12.

The distance between the semiconductor laser device 13 and the lens fixing block 15 can be maximized by fixing the collimator lens 14 to the lens mounting surface P11 in a state in which the collimator lens 14 protrudes from the lens fixing block 15 to the semiconductor laser device 13 side. The fillet F2 can be formed on the end surface P3 of the collimator lens 14. Since the distance between the semiconductor laser device 13 and the lens fixing block 15 increases, it is possible to prevent the fixing resin J, which is applied to the lens fixing block 15 in order to fix the collimator lens 14, from adhering to the laser beam emitting portion of the semiconductor laser device 13.

Forming the fillets F1 and F2 on the two crossing surfaces (the emission surface P2 and the end surface P3) in the end portion E of the collimator lens 14 is for increasing the fixing strength of the collimator lens 14 with respect to the lens fixing block 15 and is for reducing the positional deviation of the collimator lens 14 in the Z direction due to contraction or expansion of the fixing resin J. In general, in a case where two members are resin-fixed, the fixing strength in a configuration in which a fillet is formed is higher than that in a configuration in which no fillet is formed. Therefore, the fixing strength of the collimator lens 14 with respect to the lens fixing block 15 can be increased by forming the fillets F1 and F2.

Contraction or expansion of the fixing resin J is performed with the center of gravity of the fixing resin J as a reference. In other words, the fixing resin J contracts toward its center of gravity, and expands with the center of gravity as a reference. Therefore, the force acting on the collimator lens 14 when the fixing resin J contracts or expands increases as the distance between the center of gravity of the fixing resin J and the center of gravity of the collimator lens 14 increases. By forming the fillets F1 and F2 to reduce the distance between the position of the center of gravity of the fixing resin J in the Z direction and the position of the center of gravity of the collimator lens 14 in the Z direction, it is possible to reduce the positional deviation of the collimator lens 14 in the Z direction due to contraction or expansion of the fixing resin J.

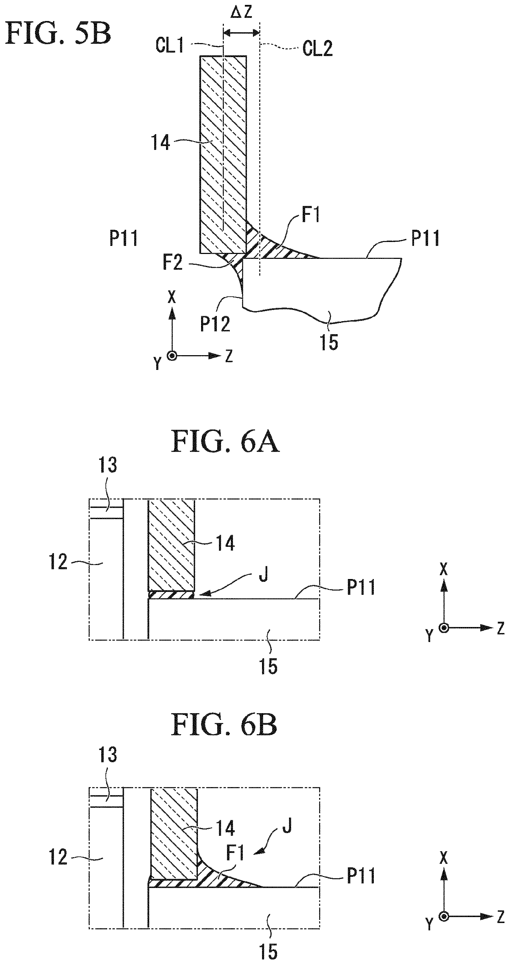

The amount of protrusion of the collimator lens 14 (amount of protrusion from the lens fixing block 15 to the semiconductor laser device 13 side) will be described. FIGS. 5A and 5B are diagrams for explaining the amount of protrusion of the collimator lens in the present embodiment. From the point of view of preventing adhesion of the fixing resin J to the semiconductor laser device 13, it is desirable to maximize the amount of protrusion of the collimator lens 14 as shown in FIG. 5B.

In the example shown in FIG. 5B, the amount of protrusion of the collimator lens 14 is set to be large enough to prevent the centroidal line (line parallel to the X axis passing through the center of gravity) CL1 of the collimator lens 14 does not cross the lens mounting surface P11. In contrast, the centroidal line CL2 of the fixing resin J crosses the lens mounting surface P11. This is because the fillet F1 is located on the lens mounting surface P11 to which the fixing resin J is applied and the volume of the fillet F1 tends to be larger than the volume of the fillet F2.

However, as the amount of protrusion of the collimator lens 14 increases, the distance between the centroidal lines CL1 and CL2, that is, a distance ΔZ between the position of the center of gravity of the fixing resin J in the Z direction and the position of the center of gravity of the collimator lens 14 in the Z direction increases. If the distance ΔZ is too large, positional deviation of the collimator lens 14 in the Z direction due to contraction or expansion of the fixing resin J occurs. Therefore, as shown in FIG. 5A, it is preferable that the amount of protrusion of the collimator lens 14 is within a range in which the centroidal line CL1 of the collimator lens 14 crosses the lens mounting surface P 11.

The lens fixing block 15 is attached to a position on the substrate 11 in consideration of the working distance of the collimator lens 14 and the amount of protrusion of the collimator lens 14 from the lens fixing block 15. Specifically, the side surface P12 of the lens fixing block 15 is attached to a position away from the semiconductor laser device 13 in the +Z direction by a distance obtained by adding the amount of protrusion of the collimator lens 14 from the lens fixing block 15 to the working distance of the collimator lens 14.

In the example shown in FIG. 5A, the distance ΔZ between the centroidal lines CL1 and CL2 can be made smaller than that in the example shown in FIG. 5B, but the distance ΔZ between the centroidal lines CL1 and CL2 is not zero. This is thought to be mainly due to the difference between the volumes of the fillets F1 and F2. That is, this is because the volume of the fillet F1 is larger than the volume of the fillet F2. Therefore, if the volumes of the fillets F1 and F2 are made almost equal, the distance ΔZ between the centroidal lines CL1 and CL2 can become almost zero. In addition, it is thought that this makes it possible to substantially eliminate the positional deviation of the collimator lens 14 in the Z direction due to contraction or expansion of the fixing resin J. Here, "volumes of the fillets F1 and F2 are almost the same" means that the volumes of the fillets F1 and F2 do not need to be exactly the same as long as it is possible to suppress the positional deviation.

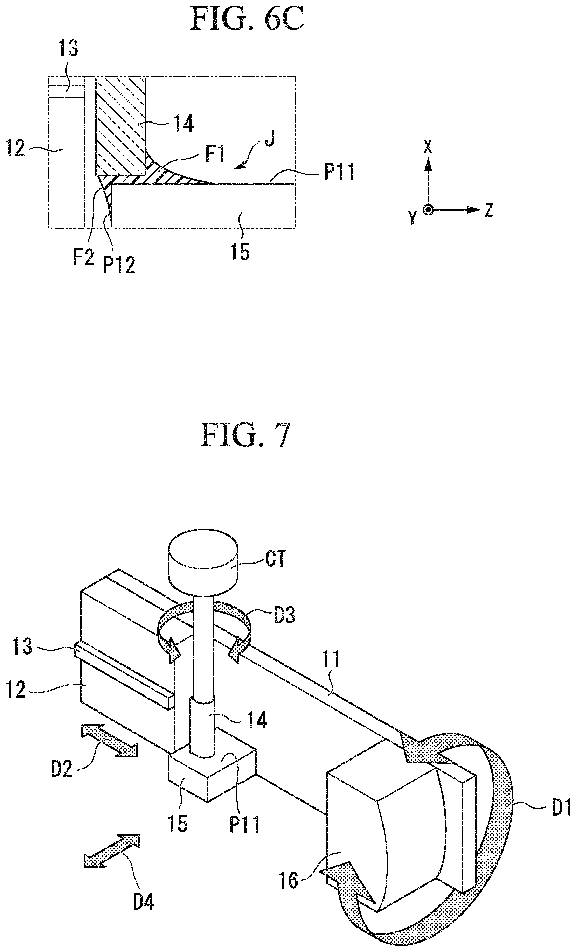

FIGS. 6A to 6C are diagrams for explaining the fixing strength of the collimator lens. FIG. 6A shows a configuration in which no fillet is formed in a fixing portion of the collimator lens 14. FIG. 6B shows a configuration in which a fillet F1 is formed in the fixing portion of the collimator lens 14. FIG. 6C shows a configuration in which the fillets F1 and F2 are formed in the fixing portion of the collimator lens 14. Hereinafter, their fixing strengths will be described.

In the configuration shown in FIG. 6A, the fixing strength is remarkably small compared with those shown in FIGS. 6B and 6C. For example, only the fixing strength of approximately 1/10 can be obtained. This is thought to be caused by the fact that no fillet is formed in the configuration shown in FIG. 6A. In the configurations shown in FIGS. 6B and 6C, the fixing strengths are almost the same. This is because, as shown in FIG. 6C, the bonding area between the collimator lens 14 and the lens fixing block 15 is reduced by causing the collimator lens 14 to protrude from the lens fixing block 15 but the reduction in the bonding area is compensated for by the formation of the fillets F1 and F2.

Thus, in the configuration shown in FIG. 6C, the collimator lens 14 is attached to the lens mounting surface P11 in a state in which the collimator lens 14 protrudes from the lens fixing block 15. On the other hand, in the configuration shown in FIG. 6C, the same degree of fixing strength as in the configuration shown in FIG. 6B can be obtained. In addition, by making the collimator lens 14 protruding from the lens fixing block 15 as shown in FIG. 6C, the collimator lens 14 can be brought closer to the semiconductor laser device 13 than those shown in FIGS. 6A and 6B can be.

As described above, in the semiconductor laser apparatus 1 according to the present embodiment, the fillets F1 and F2 are formed on the two crossing surfaces (the emission surface P2 and the end surface P3) in the end portion E of the collimator lens 14 fixed by the fixing resin J. This makes it possible to reduce the distance ΔZ between the centroidal line CL1 of the collimator lens 14 and the centroidal line CL2 of the fixing resin J. Therefore, it is possible to effectively reduce the positional deviation of the collimator lens 14 due to contraction or expansion of the fixing resin J.

### [Method of manufacturing a semiconductor laser apparatus]

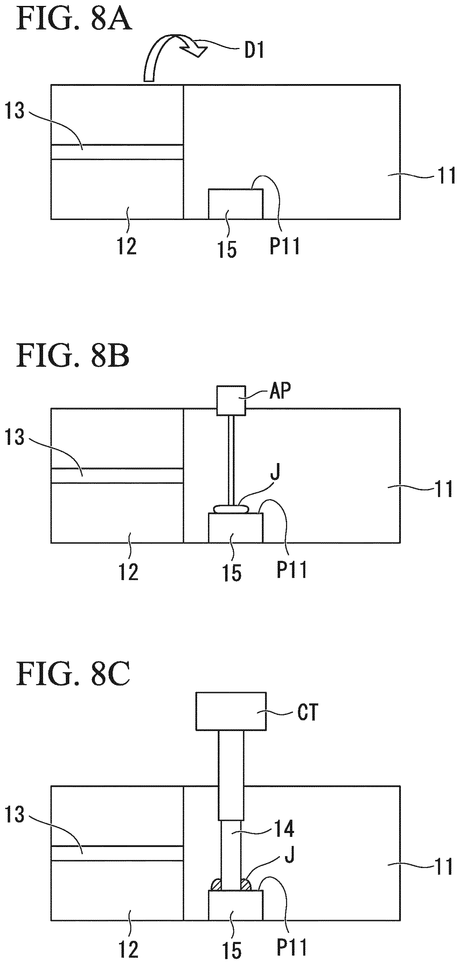

FIG. 7 is a perspective view for explaining a method of manufacturing method of a semiconductor laser apparatus according to an embodiment of the present invention. FIGS. 8A to 8D are process diagrams showing a method of manufacturing a semiconductor laser apparatus. In FIG. 7, a collimator lens 16 (SAC lens) for collimating the slow axis component of the laser beam L emitted from the semiconductor laser device 13 is shown. As shown in the diagrams, the collimator lens 16 is attached to the other end portion (end portion opposite to the end portion to which the submount 12 is attached) of the substrate 11.

The semiconductor laser apparatus 1 is manufactured by performing a step of mounting the submount 12, the semiconductor laser device 13, the lens fixing block 15, and the like on the substrate 11, a step of attaching the collimator lens 14 to the lens fixing block 15, and other steps (for example, an adjustment step). However, the process of attaching the collimator lens 14 to the lens fixing block 15 will be particularly described below. Therefore, in the initial state, as shown in FIG. 7, the submount 12, the semiconductor laser device 13, the lens fixing block 15, and the like are mounted on the substrate 11.

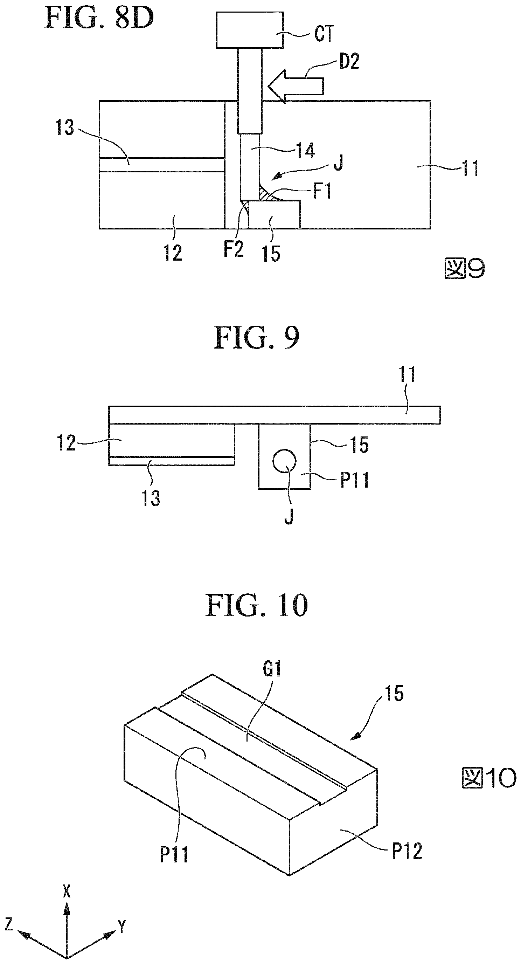

The semiconductor laser apparatus 1 is manufactured using a rotating stage (not shown), an application device AP (refer to FIG. 8B), and an adsorption collet CT (refer to FIGS. 7, 8C, and 8D). The rotating stage is a stage for rotating the substrate 11 by 90° in a rotation direction indicated by reference numeral D1 in FIG. 7 (rotation direction around the Z axis in FIGS. 1 to 3). The application device AP is a device for applying the fixing resin J onto the lens mounting surface P11 of the lens fixing block 15. In a state in which the collimator lens 14 is adsorbed, the adsorption collet CT can move in a direction perpendicular to the lens mounting surface P11 in the state shown in FIG. 7, a direction indicated by reference numeral D2 in FIG. 7 (direction along the Z axis in FIGS. 1 to 3), and a direction indicated by reference numeral D4 in FIG. 7. The adsorption collet CT can finely rotate in a rotation direction indicated by reference numeral D3 in FIG. 7.

First, as shown in FIG. 8A, the substrate 11 is rotated by 90 ° in the rotation direction D1 by the rotating stage (not shown), so that the lens mounting surface P11 of the lens fixing block 15 faces vertically upward (first step). Then, as shown in FIG. 8B, the application device AP is disposed above the lens fixing block 15, and the fixing resin J is applied onto the lens mounting surface P11 (second step).

FIG. 9 is a diagram schematically showing a fixing resin applied to the lens fixing block in the present embodiment. As shown in FIG. 9, the fixing resin J is applied to an approximate central portion of the lens mounting surface P11 of the lens fixing block 15. Specifically, the fixing resin J is applied to a position that is ahead of the laser beam emitting portion of the semiconductor laser device 13 and that is more distant than the working distance of the collimator lens 14. The volume of the fixing resin J applied onto the lens mounting surface P11 is set in consideration of the volumes of the fillets F1 and F2 shown in FIGS. 1 to 3 and the like.

Then, the collimator lens 14 (collimator lens 14 in a state in which an end portion opposite to the end portion E shown in FIG. 4 is adsorbed by the adsorption collet CT) is transported above the lens fixing block 15 by the adsorption collet CT so as to be positioned above the fixing resin J applied onto the lens mounting surface P11. Then, as shown in FIG. 8C, the adsorption collet CT is moved in the vertically downward direction, so that the end surface P3 (refer to FIG. 4) of the collimator lens 14 is in contact with the lens mounting surface P11 of the lens fixing block 15 (third step). In other words, a gap between the end surface P3 of the collimator lens 14 and the lens mounting surface P11 of the lens fixing block 15 is disposed so as to be a predetermined small gap.

Then, as shown in FIG. 8D, the adsorption collet CT is moved in the direction D2 in the diagram, so that the collimator lens 14 is aligned to become closer to the semiconductor laser device 13 (fourth step). Specifically, the relative position between the collimator lens 14 and the semiconductor laser device 13 is adjusted so that the collimator lens 14 protrudes from the lens fixing block 15 to the semiconductor laser device 13 side. At this time, in order to prevent positional deviation of the collimator lens 14 in the Z direction due to contraction or expansion of the fixing resin J, the amount of protrusion of the collimator lens 14 is within a range in which the centroidal line CL1 of the collimator lens 14 crosses the lens mounting surface P11 (refer to FIG. 5A).

As a result of the above-described steps, as shown in FIG. 8D, the fillets F1 and F2 are formed on the two crossing surfaces (the emission surface P2 and the end surface P3) in the end portion E of the collimator lens 14. If necessary, the adsorption collet CT may be moved in the direction D4 in FIG. 7 in order to adjust the emission angle of the laser beam L (adjust the angle of the laser beam L emitted from the collimator lens 14 so as to be parallel to the substrate 11). Alternatively, the adsorption collet CT may be slightly rotated in the rotation direction D3 in FIG. 7 in order to adjust the incidence surface P1 of the collimator lens 14 (adjust the angle of the incidence surface P1 with respect to the laser beam emitting portion of the semiconductor laser device 13).

After the above step ends, the fixing resin J in a state in which the fillets F 1 and F 2 are formed is cured. Accordingly, the collimator lens 14 is fixed to the lens fixing block 15 (fifth step). Specifically, in a case where the fixing resin J is an ultraviolet curable resin, the fixing resin J in the state shown in FIG. 8D is irradiated with ultraviolet light so as to be cured. In a case where the fixing resin J is a thermosetting resin, the fixing resin J in the state shown in FIG. 8D is heated to be cured.

As described above, in the method of manufacturing the semiconductor laser apparatus 1 of the present embodiment, the substrate 11 is rotated so that the lens mounting surface P11 of the lens fixing block 15 faces vertically upward, and the fi xing resin J Is applied onto the lens mounting surface P11. Then, the collimator lens 14 disposed along the vertical direction is disposed at a position where the fixing resin J is applied, and the collimator lens 14 is horizontally moved to adjust the relative position between the collimator lens 14 and the semiconductor laser device 13. Then, the fixing resin J is cured.

Accordingly, since the fillets F1 and F2 are formed on the two crossing surfaces (the emission surface P2 and the end surface P3) in the end portion E of the collimator lens 14, a semiconductor laser apparatus in which the distance ΔZ between the centroidal line CL1 of the collimator lens 14 and the centroidal line CL2 of the fixing resin J is reduced is obtained.

Thus, in the method of manufacturing the semiconductor laser apparatus 1 of the present embodiment, it is possible to manufacture a semiconductor laser apparatus capable of effectively reducing the positional deviation of the collimator lens 14 due to contraction or expansion of the fixing resin J.

In the method of manufacturing the semiconductor laser apparatus 1 according to the present embodiment, the collimator lens 14 disposed at the position of the lens mounting surface P11 where the fixing resin J is applied is horizontally moved, so that the collimator lens 14 protrudes from the lens fixing block 15 to the semiconductor laser device 13 side. Therefore, the fixing resin J applied onto the lens mounting surface P11 does not adhere to the semiconductor laser device 13. Therefore, it is possible to manufacture the semiconductor laser apparatus 1 with a high yield without a significant increase in cost.

While the embodiment of the present invention has been described above, the present invention is not limited to the above embodiment, but can be freely changed within the range of the present invention. For example, in the embodiment described above, the method of preventing the positional deviation of the collimator lens 14 in the Z direction due to contraction or expansion of the fixing resin J has mainly been described. However, the positional deviation in the Y direction may be prevented by slightly changing the shape of the lens fixing block 15.

FIG. 10 is a perspective view showing a first modification example of the lens fixing block in the embodiment of the present invention. In a lens fixing block 15 shown in FIG. 10, a groove G1 is formed along the Z direction in the central portion of the lens mounting surface P11. Due to the formation of the groove G1, the fixing resin J applied onto the lens mounting surface P11 is restricted from spreading in the Y direction due to the surface tension of the fixing resin J, and easily spreads along the longitudinal direction of the groove G1 (in FIG. 8D, the direction D2 in which the collimator lens 14 moves). Therefore, in the step shown in FIG. 8D, it is possible to prevent the center of gravity of the fixing resin J from deviating in the Y direction.

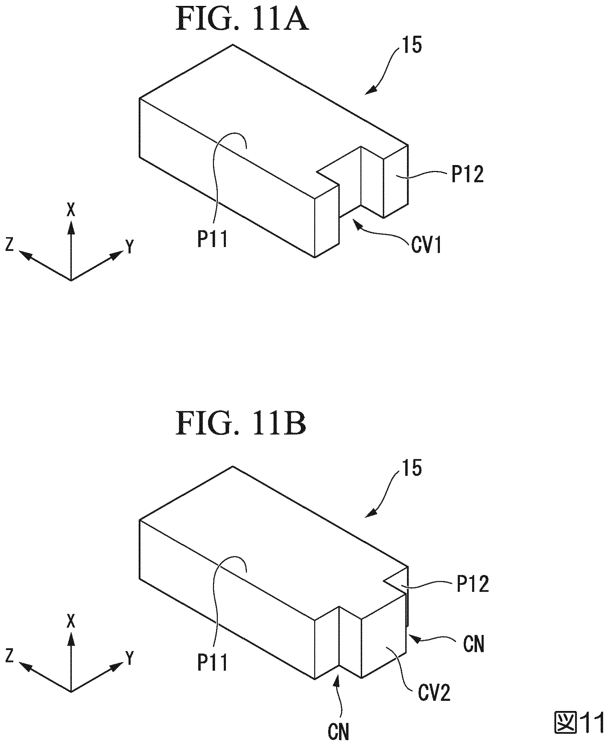

FIGS. 11A and 11B are perspective views showing a second modification example of the lens fixing block in the embodiment of the present invention. As shown in FIGS. 11A and 11B, in lens fixing blocks 15 according to this modification example, the shapes of side surfaces P12 of the lens fixing blocks 15 are different. Specifically, in the lens fixing block 15 shown in FIG. 11A, the side surface P12 of the lens fixing block 15 is formed as a recessed portion CV1. In the lens fixing block 15 shown in FIG. 11B, the side surface P12 of the lens fixing block 15 is formed as a protruding portion CV2. In FIGS. 11A and 11B, in order to facilitate understanding, the recessed portion CV1 and the protruding portion CV2 are exaggeratedly shown.

In any case where the lens fixing blocks 15 shown in FIGS. 11A and 11B are used, the collimator lens 14 is fixed so as to protrude from the side surface P12 to the -Z side. In the lens fixing block 15 shown in FIG. 11B, it is preferable that the collimator lens 14 protrudes from the side surface P12 to the -Z side and that the collimator lens 14 protrudes from the protruding portion CV2 to the -Z side.

In the lens fixing block 15 shown in FIG. 11A, a fillet F2 is formed in the recessed portion CV1. In the lens fixing block 15 shown in FIG. 11B, the fillet F2 is formed at two corner portions CN formed by the protruding portion CV2 and the side surface P12. The recessed portion CV1 shown in FIG. 11A is formed in the central portion of the side surface P12, and the fillet F2 is formed in the central portion of the side surface P12. Therefore, it is possible to prevent the center of gravity of the fixing resin J from deviating in the Y direction. The two corner portions CN shown in FIG. 11B are located on both sides of the protruding portion CV2 formed in the central portion of the side surface P12. Therefore, it is possible to prevent the center of gravity of the fixing resin J from deviating in the Y direction by equalizing the volumes of the fillets F2 formed at the two corner portions CN.

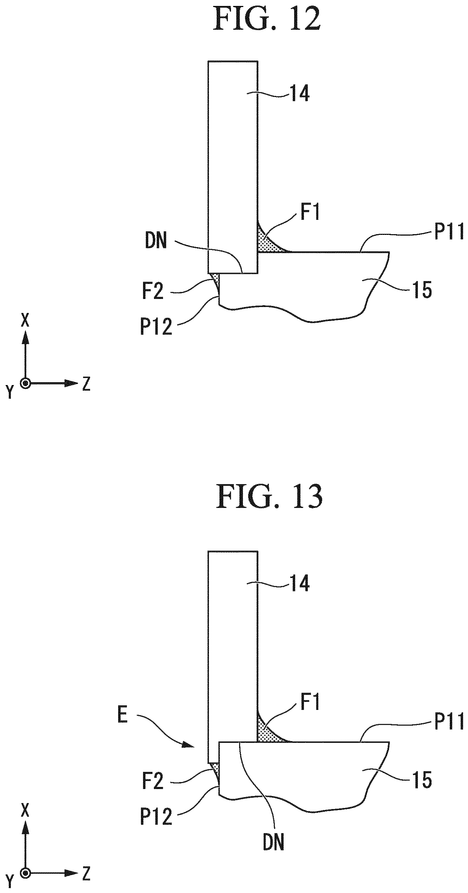

FIG. 12 is a perspective view showing a third modification example of the lens fixing block in the embodiment of the present invention. As shown in FIG. 12, in a lens fixing block 15 according to this modification example, a step portion DN is formed on the -Z side (side surface P12 side) of the lens mounting surface P11. The collimator lens 14 is attached to the step portion DN of the lens mounting surface P11 of the lens fixing block 15. In a case where the lens fixing block 15 shown in FIG. 12 is used, the collimator lens 14 may be disposed in the step portion DN. Therefore, it is possible to improve the mounting accuracy of the collimator lens 14 with respect to the lens fixing block 15.

FIG. 13 is a plan view showing a modification example of the collimator lens in the embodiment of the present invention. As shown in FIG. 13, in a collimator lens 14 according to this modification example, a step portion DN is formed on the emission surface P2 side (refer to FIG. 4) of the end portion E. In such a collimator lens 14, the step portion DN is attached so as to be engaged with a corner portion (comer portion where the lens mounting surface P11 and the side surface P12 side cross each other) of the fixing block 15. In a case where the collimator lens 14 shown in FIG. 13 is used, the step portion DN of the collimator lens 14 may be engaged with the corner portion of the fixing block 15. Therefore, in the same manner as in the example shown in FIG. 12, it is possible to improve the mounting accuracy of the collimator lens 14 with respect to the lens fixing block 15.

In the embodiment described above, as shown in FIG. 8D, the adsorption collet CT is moved in the direction D2 in the diagram, so that the collimator lens 14 is aligned to become closer to the semiconductor laser device 13. However, using a moving stage (not shown) for moving the substrate 11 in the direction D2 in FIG. 7, the substrate 11 may be made to move in a direction opposite to the direction D2 shown in FIG. 8D while fixing the adsorption collet CT.

### DESCRIPTION OF THE REFERENCE SYMBOLS

- 1:: semiconductor laser apparatus
- 11:: substrate
- 13:: semiconductor laser device
- 14:: collimator lens
- 15:: fixing block
- CL1:: centroidalline
- E:: end portion
- F1, F2:: fillet
- J:: fixing resin
- L:: laser beam
- P2:: emission surface
- P3:: end surface
- P11:: lens mounting surface
- P12:: side surface

## Claims

1. A semiconductor laser apparatus, comprising:
a semiconductor laser device that emits laser beam in a first direction;
a collimator lens that collimates a component in a second direction perpendicular to the first direction among components of laser beam emitted from the semiconductor laser device; and
a lens fixing block having a lens mounting surface perpendicular to a third direction perpendicular to the first and second directions,
wherein a first end portion of the collimator lens in the third direction is fixed to the lens mounting surface of the lens fixing block by a fixing resin, and
a fillet is formed on each of two crossing surfaces in the first end portion fixed by the fixing resin.

2. The semiconductor laser apparatus according to claim 1,
wherein the collimator lens is fixed to the lens mounting surface in a state in which the collimator lens protrudes from the lens fixing block toward the semiconductor laser device, and
the fillet is formed on a side surface of the collimator lens, which is a side surface opposite to a side facing the semiconductor laser device, and an end surface of the collimator lens, which is an end surface of a portion protruding from the lens fixing block toward the semiconductor laser device.

3. The semiconductor laser apparatus according to claim 2,
wherein the fillet formed on the side surface of the collimator lens has a shape that rises as a distance from the collimator lens decreases on the lens mounting surface, and
the fillet formed on the end surface of the collimator lens has a shape that rises as a distance from the collimator lens decreases on a surface facing the semiconductor laser device of two surfaces crossing the lens mounting surface of the lens fixing block.

4. The semiconductor laser apparatus according to claim 2 or 3,
wherein the fillet formed on the side surface of the collimator lens and the fillet formed on the end surface of the collimator lens have approximately the same volume.

5. The semiconductor laser apparatus according to any one of claims 2 to 4,
wherein the collimator lens is fixed to the lens mounting surface such that an extension line of a centroidal line of the collimator lens parallel to the third direction crosses the lens mounting surface.

6. The semiconductor laser apparatus according to any one of claims 2 to 5,
wherein, in the lens fixing block, the surface facing the semiconductor laser device of the two surfaces crossing the lens mounting surface is disposed at a position away from the semiconductor laser device by a distance obtained by adding an amount of protrusion of the collimator lens from the lens fixing block to a working distance of the collimator lens.

7. The semiconductor laser apparatus according to any one of claims 1 to 6,
wherein the fixing resin is an ultraviolet curable resin or a thermosetting resin.

8. The semiconductor laser apparatus according to any one of claims 1 to 7,
wherein the second direction is a direction along a fast axis of laser beam emitted from the semiconductor laser device.

9. A method of manufacturing a semiconductor laser apparatus including a semiconductor laser device that emits laser beam in a first direction, a collimator lens that collimates a component in a second direction perpendicular to the first direction among components of laser beam emitted from the semiconductor laser device, and a lens fixing block having a lens mounting surface perpendicular to a third direction perpendicular to the first and second directions, the method comprising:
rotating a substrate, on which the semiconductor laser device and the lens fixing block are mounted, such that the lens mounting surface faces vertically upward;
applying a fixing resin onto the lens mounting surface of the lens fixing block;
arranging the collimator lens, which is disposed along a vertical direction, at a position where the fixing resin is applied from above the lens mounting surface;
adjusting a relative position between the collimator lens and the semiconductor laser device by horizontally moving one of the collimator lens and the substrate; and
curing the fixing resin.

10. The method of manufacturing a semiconductor laser apparatus according to claim 9,
wherein the step of applying the fixing resin includes applying the fixing resin at a position, which is more distant than a working distance of the collimator lens, on the lens mounting surface.

11. The method of manufacturing a semiconductor laser apparatus according to claim 9 or 10,
wherein the step of adjusting the relative position between the collimator lens and the semiconductor laser device includes adjusting the relative position between the collimator lens and the semiconductor laser device such that the collimator lens protrudes from the lens fixing block toward the semiconductor laser device.

12. The method of manufacturing a semiconductor laser apparatus according to claim 11,
wherein the step of adjusting the relative position between the collimator lens and the semiconductor laser device includes adjusting the relative position between the collimator lens and the semiconductor laser device such that the collimator lens protrudes from the lens fixing block toward the semiconductor laser device and a centroidal line of the collimator lens crosses the lens mounting surface.
